# EUROPEAN PATENT SPECIFICATION

(11) **EP 0 250 886 B1**
(45) Date of publication and mention of the grant of the patent: **28.07.1993**
(21) Application number: 87107808.5
(22) Date of filing: 29.05.1987
(51) Int. Cl.: H01L 29/205, H01L 29/26, H01L 29/80, H01L 39/12, H01L 39/22

(54) **Semiconductor heterostructure adapted for low temperature operation**
Halbleiterheterostruktur geeignet für Tieftemperatureinsatz
Hétérostructure de semi-conducteur adaptée pour opération à température basse

(30) Priority: 20.06.1986 US 876552
(43) Date of publication of application: 07.01.1988
(73) Proprietor: International Business Machines Corporation, Armonk, N.Y. 10504 (US)
(72) Inventor: Jackson, Thomas Nelson, Peekshill, N.Y. 10 566 (US); Kleinsasser, Alan Willis, Putnam Valley, N.Y. 10 579 (US); Woodall, Jerry MacPherson, Bedford Hills, N.Y. 10 507 (US)
(74) Representative: Mönig, Anton, Dipl.-Ing.

(56) References cited:
- EP-A- 0 025 742
- EP-A- 0 114 962
- EP-A- 0 147 482

## Description

The technical field of the invention is in semiconductor devices particularly suited for low temperature operation where very small signal levels are involved. Compound semiconductors have been found promising in the low temperature field for such advantages as increased mobility, but major disadvantages of such compound semiconductors have been an inherent barrier at an interface with an external metal which is particularly detrimental where small signals are employed and involved structural arrangements because of the short distances and thin structures.

The compound semiconductor materials that have a small energy gap, particularly InAs and InSb, have the desirable carrier mobility property and have a further advantage that the conduction band energy level is below the Fermi level and thus no barrier is present at an interface with a metal contact.

A generalized survey of low temperature superconductor structures including these materials is reported in the American Institute of Physics Conference Proceedings No. 44, 1978.

The desirability of fabricating Schottky and insulated gate type field effect transistors (IGFET) in InAs and InSb involving superconductivity is reported in J. Appl. Phys. 51 (5), May 1980.

The problems of close electrode spacing in superconductive devices is reported in Appl. Phys. Lett. 46 (1), 1 Jan. 1985, p.92 for n-InAs single crystal material and in Physical Review Letters 54 (22), June 1985, p.2449 for p-InAs material with an inversion layer.

A superconducting single crystal three-terminal device field effect transistor involving an insulated gate positioned on the opposite side of the channel from the source and drain electrodes is reported in IEEE Electron Device Letters, Vol. EDL-6, No. 6, June 1985, p.297.

A specific low temperature transistor device is described in EP-A-0 147 482, comprising a tunnel channel arranged between source and drain electrodes. The tunnel current is generated in a low band gap semiconductor layer on an insulatlng substrate. Materials and dimensions are chosen to form a low height energy barrier permitting control of the tunneling current by means of signals in the mV range applied to the gate terminal.

The use of a heterojunction as the gate of a field effect transistor has been employed in the higher temperature semiconductor art as illustrated in U.S. Patent 4,583,105 but such an application would require dealing with the aggravated effect of barriers at the metal interfaces at low signal levels.

Another heterojunction field effect transistor is disclosed in EP-A-0 114 962. The channel region lies in a thin semiconducting crystal layer, epitaxially grown on a semi-insulating substrate. Fermi and conduction band levels are adjusted so that gate and channel regions of the FET nearly have the same barrier height. The threshold voltage of the device thus lies about zero volts.

In the prior art, attempts to gain the advantages that the low band gap semiconductors should provide has been accompanied by difficulty in fabricating structures.

FIG. 1 is an illustration of the compound semiconductor heterostructure of the invention.

FIG. 2 is an illustration of a superconducting device employing the invention.

FIG. 3 is a partial band energy diagram illustrating a metal interface with the semiconductor heterostructure of the invention.

FIG. 4 is an illustration of a low temperature heterojunction field effect transistor employing the invention.

FIG. 5 is a partial band energy diagram illustrating the band energy relationships through the gate electrode of FIG. 4.

FIG. 6 is a partial band energy diagram showing an alternate gate structure.

The invention is a compound semiconductor heterostructure for low temperature devices compatible with the planar fabrication technology standard in the art.

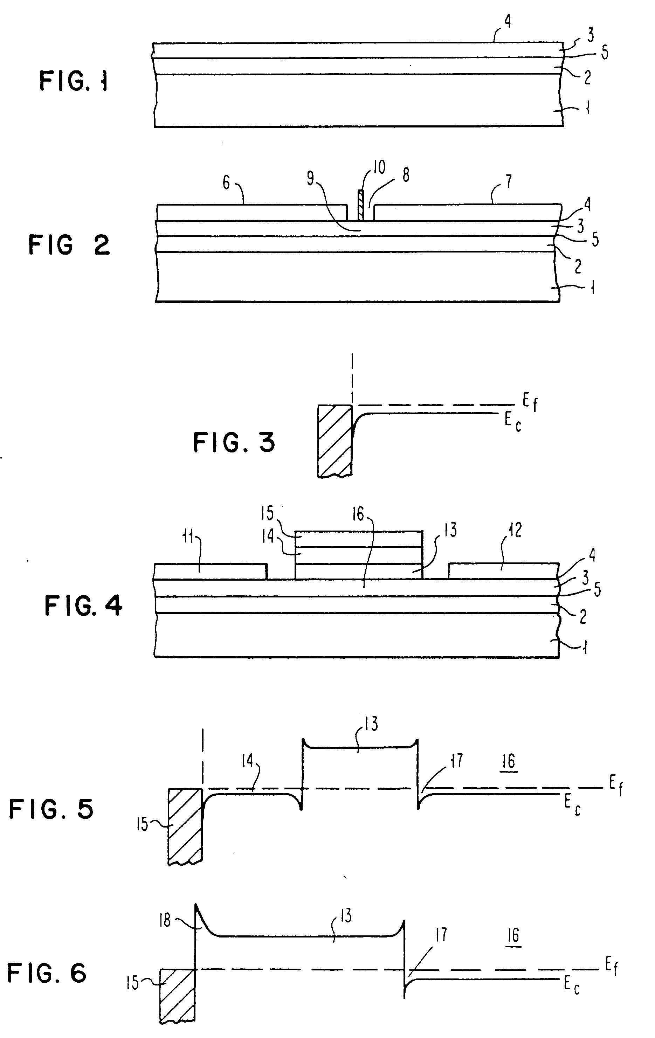

Referring to FIG. 1, a substrate 1 is provided having thereon a high resistivity accommodation layer 2 and deposited thereon a layer 3 in which devices may be fabricated of a low band gap compound semiconductor having a lattice constant either the same as or different from that of layer 2. The accommodation layer 2 can conveniently provide the required resistivity by being of a higher band gap undoped semiconductor material.

It is necessary that a parallel current path to the conduction in the layer 3 be prevented. The substrate 1 provides a supporting function and is usually of compensated semiconductor material, known as semi-insulating, with a resistivity of > 10⁷ ohm cm. The accommodation layer 2 insures a high resistance by being undoped of high purity with an impurity density less than 10¹⁴ atoms/cc and is thin, of the order of 1 micron.

The low band gap compound semiconductor materials, such as InAs, InSb and alloys thereof such as GaInAs, have the characteristics that they have the device properties of high carrier mobility and high saturation drift velocity and surface Fermi levels pinned in or near the conduction band.

An advantage of the use of the low band gap semiconductor layer 3 in this invention is a relaxation of the need for single crystal materials. Normally, in large band gap materials such as GaAs, the Fermi level is pinned near mid-gap at grain boundaries causing barriers to carrier flow, however, for low band gap materials, the Fermi level is pinned in or near the conduction band for both surfaces and grain boundaries, providing barrierless carrier flow. In addition, the surface and interface Fermi level pinning that occurs in low band gap materials is small compared to high band gap materials and does not prevent the movement of the Fermi level by doping or gate control means.

The energy levels of these materials are such that with moderate doping control the conduction band can be placed lower than the Fermi level. This operates to eliminate inherent barriers with metal contacts encountered with other types of materials and lastly, being a semiconductor, the materials when used as a channel in a field effect transistor can be constructed such that conduction in the channel can be influenced at a heterojunction with another semiconductor material and an inversion layer can be employed for the channel.

The device layer 3 is compatible with planar type technology on surface 4 and is thin, of the order of 100 nanometers, and a layer of that thickness must be supported. Since there is no significant resistivity as superconducting temperatures are approached, the layer 2 must have high resistivity to prevent an alternate current path to that in the region 3 and for satisfactory semiconductor performance in the region 3, the density of carrier traps must be a minimum.

Referring next to FIG. 2, the heterostructure of the invention is fabricated in the form of a planar superconductor normal metal superconductor (SNS) weak link type device well known in the superconducting art.

In the device of FIG. 2, superconducting electrical contacts 6 and 7 are applied on the surface 4 of the device layer 3 with a gap which will be the superconducting region. The gap is labelled 8. The superconducting region would be labelled 9, that is the portion of the layer 3 under the gap and a current control gate 10 is shown in the gap region.

The InAs in the layer 3 which is thin provides improved control over the bulk InAs material used in most other devices, not constructed in accordance with applicants' heterostructure. The external superconducting metal contacts 6 and 7 do not form a barrier at the interface with the semiconductor 3 at the interface 4.

Referring to FIG. 3, an illustration of the barrier. Since the conduction band is lower than the Fermi level at the interface, no barrier to carrier flow between the metal and the semiconductor takes place and consequently nearly perfect ohmic contacts are provided. This avoids the deleterious effects to superconducting pair conduction caused by Schottky barrier contacts on other materials.

The devices in the heterostructure of the invention may be readily isolated by merely etching through to the accommodation layer 2. The thickness of the channel 9 is controlled by the selecting of the thickness of the layer 3 and electron mobility in the region 9 is generally higher in low band gap semiconductor material than other materials employing superconducting weak link structures.

Referring next to FIG. 4, the heterostructure of the invention is employed as a field effect transistor. In the field effect transistor of the invention, the source 11 and drain 12 electrodes are positioned on the surface 4 of the semiconductor layer 3. On the surface of the layer 4, a region of higher band gap semiconductor material 13 is positioned between the source and drain electrodes 11 and 12 to serve as a gate and in order to insure that there is no inherent barrier between the higher band gap semiconductor material 13 and a metal electrode, a region of low band gap semiconductor material in which the conduction band is below the Fermi level 14 is formed on the material 13 and provides a contact as shown in FIG. 3 between a metal 15 and the higher band gap semiconductor 13.

Referring next to FIG. 5, the heterostructure of the invention provides a band diagram as illustrated through the gate region in which there is essentially no barrier between the metal 15 and the low band gap semiconductor material 14.

Similarly, at the heterojunction gate, there is a sharp band offset to the material 13 and then another sharp band offset at the interface between the material 13 and the channel 16 which is either a portion of the layer 3 or in the alternative an electron gas in the inversion layer at the interface between the region 13 and 16 which is labelled 17 in the band diagram of FIG. 5.

Referring to FIG. 6, the use of low band gap material may be replaced by a Schottky barrier 18 serving as contact to the layer 13.

As one illustration, the heterostructure of the invention may have as a substrate 1 GaAs, accommodation layer 2 CdTe and device layer 3 InAs, and as another illustration, the device layer 3 may be InSb and the substrate 1 and accommodation layer 2 are CdTe in a single element.

A principle advantage of the heterostructure of the invention is the providing of a thin layer 3 having a surface on which planar type technology for low temperature devices can be practiced and the layer 3 is provided with all the semiconductor advantages, yet any potential parallel current path in the accommodation layer 2 is avoided by the high resistivity of layer 2. Devices made in the layer 3 of the heterostructure of the invention are readily isolated by etching through layer 3.

In accordance with the invention, it should be noted that the low band gap, high band gap, and substrate material described above need not be monocrystalline, lattice matched or epitaxial.

Heretofore in the art, an accommodation layer between a substrate and a device layer was closely lattice matched to the lattice of the device layer but when that is done, there is, at the interface between the layers, a planar high density grid of misfit crystal dislocations.

In accordance with the invention, it has been found that if the material of layer 2 is selected to have a greater than 1.5% lattice difference with respect to the material of the layer 3, the misfit dislocations do not form in a grid at the interface 5 between the layers 2 and 3, but rather epitaxial layers grow so that the misfit dislocations are spread over three dimensions, which in turn produces a 10⁷ reduction in concentration and hence better semiconductor material in the layer 3.

The material InAs in monocrystalline form as layer 3 when epitaxial with undoped high resistivity GaAs with a 7% lattice mismatch exhibits an electron mobility of 5000 → 6000 cm²/V sec at room temperature and at 4°K.

It will be apparent to one skilled in the art that should properties of the substrate 1 and the material of the layer 3 be such that the > 1.5% lattice mismatch and the high resistivity can be satisfied, a separate layer 2 would not be necessary. In practice, however, the layer 1 is usually a plentiful material such as alumina or sapphire and the layer 2 also provides an intermediate lattice accommodation such as would occur with gallium arsenide.

In the application of the heterostructure of the invention, as a low temperature heterojunction metal semiconductor field effect transistor, referring to FIG. 4, the region 1 would be semi-insulating GaAs having a region 2 of undoped epitaxial GaAs. The region 3 would be n-conductivity type InAs, approximately 100 nanometers thick, doped around 2x10¹⁸ atoms/cc. The channel length of the region 6 between electrodes 4 and 5 which would serve as the source and drain is of the order of 500 nanometers and the gate of high band gap GaAlAs has a width of the order to 300 nanometers. The device would have a threshold voltage of approximately 100 millivolts.

Where the heterostructure of the invention is employed as a superconductive device, as shown in FIG. 2, the region 3 would be of n-type InAs, approximately 100 nanometers thick, doped from 2x10¹⁷ to 2x10²⁰ atoms/cc with silicon. The region 2 would be an undoped 1 micron thick GaAs buffer layer on a semi-insulating GaAs substrate 1. The electrodes 6 and 7 are about 80 nanometers thick niobium which is applied by patterning, employing an e-beam liftoff process, standard in the art. The spacing of the region 8 is of the order of 250 nanometers. A gate 10 is niobium about 100 nanometers.

What has been described is a low band gap semiconductor heterostructure having a surface adaptable to planar processing and all semiconductor properties supported by a fabrication constraint relaxing substrate that does not provide a low impedance parallel current path.

## Claims

1. Semiconductor heterostructure comprising in combination:
a planar layer (3) of low band gap compound semiconductor material with essentially parallel first (4) and second faces (5) having said first face exposed and being deposited onto a high resistivity accommodation layer (2) contiguous with said second face, said accommodation layer (2) being supported by an insulating or semi-insulating substrate (1), wherein said accommodation layer provides an intermediate lattice accommodation between said planar layer (3) and said substrate (1) such that the resultant misfit dislocations are spread over three dimensions.

2. Heterostructure of claim 1, wherein said accommodation layer (2) consists of an undoped high band gap semiconductor material, preferably taken from the group of GaAs and CdTe.

3. Heterostructure of claim 1 or 2, wherein said planar low band gap layer (3) is taken from the group of InAs, InSb and InGaAs.

4. Heterostructure of claim 1, 2 or 3, wherein said substrate consists of GaAs, alumina or sapphire.

5. Heterostructure of any one of the claims 1 - 4, wherein said low band gap planar layer (3) and said accommodation layer (2) are monocrystalline.

6. The heterostructure of any one of the claims 1 - 5, wherein said thickness dimension of said planar low band gap layer (3) is of the order of 100 nanometers and said thickness dimension of said accommodation layer (2) is 1 micrometer.

7. Heterostructure of any one of the claims 1 - 6, including first and second superconductive electrodes (6, 7) positioned on said exposed face of said planar layer (3) separated by a gap (8) and a gate member (10) in contact with said exposed face in said gap (8).

8. Heterostructure of claim 7, wherein that superconducting electrodes (6, 7) comprise thin layers of niobium having preferably a thickness of about 80 nm.

9. Heterostructure of claim 7 or 8, wherein said gap (8) separating said electrodes (6, 7) has a width of about 250 nm.

10. Heterostructure of claim 7, 8 or 9, wherein said gate member (10) consists of niobium.

11. Heterostructure of any one of claims 1 - 6 including source and drain electrodes (11, 12) positioned on said exposed face of said planar layer (3) and separated by a channel length opening,
a higher band gap compound semiconductor gate (13) contiguous with said exposed face in said channel length opening and contact means (14, 15) to said gate.

12. Heterostructure of claim 11, where said contact means includes a region (14) of low band gap compound semiconductor material positioned between said high band gap compound semiconductor material gate (13) and a contact metal (15).

13. Heterostructure of claim 11, where said contact means (15) is a metal-Schottky barrier external electrode to said higher band gap compound semiconductor material gate.

14. Heterostructure of claim 11, 12 or 13, wherein said channel length is about 500 nm and said gate has a width of about 300 nm.

## Patentansprüche

1. Halbleiter-Heterostruktur, die folgendes in Kombination umfaßt:
eine planare Schicht (3) aus einem Verbindungshalbleitermaterial mit kleiner Bandlücke mit grundsätzlich parallelen ersten (4) und zweiten Flächen (5), wobei die erste Fläche exponiert und auf einer Anordnungsschicht mit hoher Resistivität aufgebracht ist, welche mit der zweiten Fläche zusammenhängend ist, wobei die Anordnungsschicht (2) von einem isolierenden oder halbisolierenden Substrat (1) unterstützt wird, in dem die Anordnungsschicht eine Zwischengitterakkommodation zwischen der planaren Schicht (3) und dem Substrat (1) bietet, so daß die resultierenden Fehlversetzungen über drei Dimensionen verteilt sind.

2. Heterostruktur gemäß Anspruch 1, in der die Anordnungsschicht (2) aus einem nicht dotierten Halbleitermaterial mit großer Bandlücke besteht, das vorzugsweise aus der Gruppe der GaAs und CdTe-Verbindungen stammt.

3. Heterostruktur gemäß Anspruch 1 oder 2, in der die planare Schicht (3) mit kleiner Bandlücke aus der Gruppe der InAs-, InSb- und InGaAs-Verbindungen stammt.

4. Heterostruktur gemäß Anspruch 1, 2 oder 3, in der das verwendete Substrat aus GaAs, Aluminium oder Saphir besteht.

5. Heterostruktur gemäß einem der Anspruche 1 - 4, in der die planare Schicht mit kleiner Bandlücke und die Anordnungsschicht (2) monokristallin sind.

6. Heterostruktur gemäß einem der Ansprüche 1 - 5, in der die Stärke der planaren Schicht (3) mit kleiner Bandlücke in der Größenordnung von 100 Nanometern liegt und die Stärke der Anordnungsschicht (2) 1 Mikrometer beträgt.

7. Heterostruktur gemäß einem der Ansprüche 1 - 6, welche erste und zweite supraleitende Elektroden (6, 7) enthält, die auf der exponierten Fläche der planaren Schicht (3) angeordnet und durch eine Lücke (8) getrennt sind, wobei ein Gate-Bauteil (10) in Kontakt mit der exponierten Fläche in dieser Lücke (8) steht.

8. Heterostruktur gemäß Anspruch 7, wobei die supraleitenden Elektroden (6, 7) dünnen Niobium-Schichten umfassen, die eine Stärke von vorzugsweise 80 nm besitzen.

9. Heterostruktur gemäß Anspruch 7 oder 8, in der die Lücke (8), welche die Elektroden (6, 7) trennt, eine Breite von etwa 250 nm hat.

10. Heterostruktur gemäß Anspruch 7, 8 oder 9, in der das Gate-Bauteil (10) aus Niobium besteht.

11. Heterostruktur gemäß einem der Ansprüche 1 - 6 mit Source- und Drain-Elektroden (11, 12), die auf der exponierten Fläche der planaren Schicht (3) angeordnet und durch eine Kanallängenöffnung getrennt sind,
einem Gate eines Verbindungshalbleiters (13) mit größerer Bandlücke, das mit der exponierten Fläche in jener Kanallängenöffnung aneinandergrenzt und Kontaktmittel (14, 15) zu diesem Gate.

12. Heterostruktur gemäß Anspruch 11, in der das Kontaktmittel eine Region (14) mit Halbleitermaterial mit kleiner Bandlücke enthält, die zwischen dem Gate aus Halbleitermaterial mit großer Bandlücke (13) und einem Kontaktmetall (15) angeordnet ist.

13. Heterostruktur gemäß Anspruch 11, in der als Kontaktmittel (15) eine externe metallene Schottky-Sperrelektrode an dem Gate aus Halbleitermaterial mit großer Bandlücke verwendet wird.

14. Heterostruktur gemäß Anspruch 11, 12 oder 13, in der die Kanallänge etwa 500 nm beträgt und das Gate eine Breite von etwa 300 nm besitzt.

## Revendications

1. Une hétérostructure de semi-conducteurs comprenant divers éléments combinés :
une couche planaire (3) de matériaux semi-conducteurs composés à faible espacement de bande, présentant une première face (4) et une seconde face (5) pratiquement parallèles, ladite première face, exposée, étant déposée sur une couche support à haute résistivité (2) contiguë à ladite seconde face, ladite couche support (2) étant elle-même portée par un substrat isolant ou semi-isolant (1), ladite hétérostructure étant caractérisée en ce que ladite couche support constitue une structure maillée intermédiaire entre ladite couche planaire (3) et ledit substrat (1), de telle sorte que les dislocations de désajustement résultantes se répartissent sur trois dimensions.

2. Une hétérostructure conformément à la revendication 1, caractérisée en ce que ladite couche support (2) est constituée d'un matériau semi-conducteur à fort espacement de bande non dopé, sélectionné de préférence dans le groupe de GaAs et CdTe.

3. Une hétérostructure conformément à la revendication 1 ou 2, caractérisée en ce que ladite couche planaire à faible espacement de bande (3) est sélectionnée dans le groupe de matériaux InAs, InSb et InGaAs.

4. Une hétérostructure conformément à la revendication 1, 2 ou 3, caractérisée en ce que ledit substrat est constitué de GaAs, d'alumine ou de saphir.

5. Une hétérostructure conformément à l'une quelconque des revendications 1 à 4, caractérisée en ce que ladite couche planaire à faible espacement de bande (3) et ladite couche support (2) sont monocristallines.

6. Une hétérostructure conformément à une quelconque des revendications 1 à 5, caractérisée en ce que la cote d'épaisseur de ladite couche planaire à faible espacement de bande (3) est de l'ordre de 100 nanomètres et la cote d'épaisseur de ladite couche support (2) est d'1 micromètre.

7. Une hétérostructure conformément à l'une quelconque des revendications 1 à 6, comprenant une première et une seconde électrodes superconductrices (6 et 7) positionnées sur ladite face exposée de ladite couche planaire (3), séparées par un espacement (8) et par un bras de commutation (10), lui-même en contact avec ladite face exposée, au sein dudit espacement (8).

8. Une hétérostructure conformément à la revendication 7, caractérisée en ce que lesdites électrodes superconductrices (6 et 7) comprennent de minces couches de niobium présentant, de préférence, une épaisseur d'environ 80 nanomètres.

9. Une hétérostructure conformément à la revendication 7 ou 8, caractérisée en ce que ledit espacement (8) séparant lesdites électrodes (6 et 7) présente une largeur d'environ 250 nanomètres.

10. Une hétérostructure conformément à la revendication 7, 8 ou 9, caractérisée en ce que ledit bras de commutation (10) est constitué de niobium.

11. Une hétérostructure conformément à l'une quelconque des revendications 1 à 6, comprenant une électrode source et une électrode drain (11 et 12) positionnées sur ladite face exposée de ladite couche planaire (3) et séparées par une ouverture de longueur de canal,
un commutateur à semi-conducteurs composés à fort espacement de bande (13) contigu à ladite face exposée dans ladite ouverture de longueur de canal et des moyens de contact (14 et 15) avec ledit commutateur.

12. Une hétérostructure conformément à la revendication 11, caractérisée en ce que lesdits moyens de contact comprennent une région (14) de matériaux semi-conducteurs composés à faible espacement de bande, positionnée entre ledit commutateur à semi-conducteurs composés à fort espacement de bande (13) et un métal de contact (15).

13. Une hétérostructure conformément à la revendication 11, caractérisée en ce que ledit moyen de contact (15) est une électrode externe à barrière métallique à effet Schottky reliée audit commutateur à semi-conducteurs composés à espacement de bande supérieur.

14. Une hétérostructure conformément à la revendication 11, 12 ou 13, caractérisée en ce que ladite longueur de canal est d'environ 500 nanomètres et ledit commutateur présente une largeur d'environ 300 nanomètres.
